# EUROPÄISCHE PATENTSCHRIFT

(11) **EP 3 164 725 B1**
(45) Veröffentlichungstag und Bekanntmachung des Hinweises auf die Patenterteilung: **21.04.2021**
(21) Anmeldenummer: 15732673.7
(22) Anmeldetag: 29.06.2015
(51) Int. Cl.: G01R 31/333, H01H 9/00, G01R 31/327, G01R 31/62

(54) **VERFAHREN UND VORRICHTUNG ZUM PRÜFEN EINES STUFENSCHALTERS EINES TRANSFORMATORS**
METHOD AND DEVICE FOR TESTING A TAP CHANGER OF A TRANSFORMER
PROCÉDÉ ET DISPOSITIF DE CONTRÔLE D'UN COMMUTATEUR À GRADINS D'UN TRANSFORMATEUR

(30) Priorität: 02.07.2014 AT 504602014
(43) Veröffentlichungstag der Anmeldung: 10.05.2017
(73) Patentinhaber: Omicron electronics GmbH, 6833 Klaus (AT)
(72) Erfinder: RÄDLER, Michael, 6833 Klaus (AT); UNTERER, Boris, 6800 Feldkirch (AT)
(74) Vertreter: Banzer, Hans-Jörg
(86) Internationale Anmeldenummer: PCT/EP2015/064713
(87) Internationale Veröffentlichungsnummer: WO 2016/001150

(56) Entgegenhaltungen:
- EP-A1- 2 244 272
- EP-B1- 2 524 385
- DE-A1-102013 102 709

## Beschreibung

Die vorliegende Erfindung betrifft ein Verfahren und eine Vorrichtung, um einen Stufenschalter eines Transformators, insbesondere eines Leistungstransformators, zu überprüfen.

Die Druckschrift EP 2 244 272 A1 beschreibt einen Stufenschalter für einen Transformator und ein Verfahren zum Messen einer Kontaktfolge eines Stufenschalters.

Die Druckschrift EP 2 524 385 B1 offenbart die Messung der zeitlichen Reihenfolge von während der Betätigung eines Laststufenschalters nacheinander ablaufenden einzelnen Schaltungen von unterschiedlichen Kontakt- und Schaltelementen.

Elektrische Leistungstransformatoren, welche beispielsweise bei der Energieerzeugung, Energieübertragung, Energieverteilung oder bei Industrieanwendungen eingesetzt werden und für Leistungen größer 1 MW ausgelegt sind, umfassen häufig so genannte Stufenschalter, um das Übersetzungsverhältnis des jeweiligen Transformators beispielsweise an bestimmte Lastverhältnisse geringfügig anpassen zu können. Stufenschalter, welche auch im Betrieb des Transformators bzw. unter Last, d.h. ohne Unterbrechung des Betriebs, geschaltet werden können, werden häufig auch als Laststufenschalter ("On Load Tap Changer" (OLTC)) bezeichnet. Dazu ist die Wicklung des Transformators als eine so genannte Stufenwicklung ausgeführt, wobei Abgriffe bzw. Anzapfungen dieser Stufenwicklung an den Stufenschalter geführt sind, welcher dann im Betrieb des Transformators von einem Abgriff zu einem anderen Abgriff umschaltet, um so das Übersetzungsverhältnis des Transformators zu ändern.

Da die Wicklungen eines Transformators jeweils eine große Induktivität darstellen, ist ein Umschalten zwischen verschiedenen Übersetzungsverhältnissen nicht problemlos zu realisieren, da es nicht möglich ist, den Stromfluss durch eine Wicklung einfach zu unterbrechen. Daher ist ein Stufenschalter derart ausgestaltet, dass der Strom zu jedem Zeitpunkt durch die Wicklung fließen kann. Häufig schaltet der Stufenschalter zu diesem Zweck den Strom, welcher durch die Wicklung fließt, mit Hilfe von Widerständen um, um dadurch das Übersetzungsverhältnis zu ändern. Der Umschaltvorgang muss rasch durchgeführt werden, um eine übermäßige Erwärmung der Widerstände zu vermeiden. Aufgrund der aufwändigen und damit fehleranfälligen Mechanik der Stufenschalter ist eine regelmäßige Überprüfung jedes Stufenschalters ratsam.

Daher stellt sich die vorliegende Erfindung die Aufgabe, die Überprüfung eines Stufenschalters gegenüber dem Stand der Technik zu verbessern.

Erfindungsgemäß wird diese Aufgabe durch ein Verfahren zum Prüfen eines Stufenschalters eines Transformators nach Anspruch 1 und durch eine Vorrichtung zum Prüfen eines Stufenschalters eines Transformators nach Anspruch 8 gelöst. Die abhängigen Ansprüche definieren bevorzugte und vorteilhafte Ausführungsformen der vorliegenden Erfindung.

Im Rahmen der vorliegenden Erfindung wird ein Verfahren zum Prüfen eines Stufenschalters eines Transformators bereitgestellt. Dabei ist der Stufenschalter ausgestaltet, um (unter Last) ein Übersetzungsverhältnis des Transformators zu ändern. Das erfindungsgemäße Verfahren umfasst folgende Schritte:
- Erzeugen eines Testsignals, welches einer Wicklung des Transformators und dem Stufenschalter zugeführt wird. Bei dem Testsignal handelt es sich um einen elektrischen Strom, welcher durch die Wicklung und den in Reihe mit der Wicklung liegenden Stufenschalter fließt und typischerweise zwischen wenigen Ampere und etwa 100 Ampere stark ist.
- Betätigen des Stufenschalters, wobei bei dem Betätigen des Stufenschalters das Übersetzungsverhältnis des Transformators geändert wird.
- Erfassen eines transienten elektrischen Widerstandswerts des Transformators während der Betätigung des Stufenschalters, wobei der elektrische Widerstandswert abhängig von dem Testsignal ist. Zur Überprüfung des Stufenschalters anhand des elektrischen Widerstandswerts oder genauer anhand eines zeitlichen Verlaufs des Widerstandswerts wird insbesondere mindestens eine Messgröße, beispielsweise ein durch die Wicklung und den in Reihe geschalteten Stufenschalter fließender Strom und/oder eine an der Wicklung abfallende Spannung, gemessen, wobei sich die mindestens eine Messgröße (und damit der Widerstandswert) durch die Betätigung des Stufenschalters abhängig von dem erzeugten Testsignal ändert. Diese mindestens eine Messgröße ist entweder selbst der Widerstandswert oder umfasst eine oder mehrere Messgrößen (z.B. Strom und Spannung), aus welchen der Widerstandswert bestimmt werden kann. Der zeitliche Verlauf der mindestens einen Messgröße und damit des Widerstandswerts kann beispielsweise erfasst werden, indem die mindestens eine Messgröße während eines vorbestimmten Zeitintervalls kontinuierlich oder zu bestimmten Zeitpunkten innerhalb dieses Zeitintervalls (z.B. 100 ms) erfasst wird. Dabei beginnt das Zeitintervall insbesondere direkt vor oder kurz nach dem Beginn der Betätigung des Stufenschalters und endet, nachdem das Übersetzungsverhältnis durch den Stufenschalter geändert wurde oder nachdem die gröbsten Änderungen der Messgröße aufgrund der Betätigung des Stufenschalters bzw. des Umschaltvorgangs abgeklungen sind.

Anhand des transienten (d.h. nicht stationären) Widerstandswerts, welcher während der Betätigung des Stufenschalters erfasst wird, oder anhand des zeitlichen Verlaufs des Widerstandswerts kann die Entscheidung, ob der Stufenschalter korrekt arbeitet oder nicht, wesentlich besser und einfacher getroffen werden, als dies nach dem Stand der Technik der Fall ist. Dabei kann der erfasste Widerstandswert und der zeitliche Verlauf des Widerstandswerts insbesondere anhand historischer Daten (z.B. vorher erfassten Widerstandswerten oder vorher erfassten zeitlichen Verläufen von Widerstandswerten bei nachweislich korrekt arbeitenden Transformatoren) ausgewertet werden, um zu entscheiden, ob der Stufenschalter aktuell korrekt arbeitet.

Gemäß einer bevorzugten erfindungsgemäßen Ausführungsform kann es sich bei dem Transformator um einen Mehrphasen-Transformator (z. B. einen Dreiphasenwechselstrom-Transformator) handeln. Bei einem Mehrphasen-Transformator ist für jede Phase des Transformators ein separater Stufenschalter vorhanden, welcher ausgestaltet ist, um (unter Last) ein Übersetzungsverhältnis des Transformators zu ändern. Zum Prüfen der Stufenschalter wird für jede Phase des Transformators gleichzeitig jeweils ein Testsignal erzeugt. Pro Phase wird dieses Testsignal einer der jeweiligen Phase zugeordneten Wicklung des Transformators und dem dieser Wicklung zugeordneten Stufenschalter zugeführt. Wenn es sich bei den Testsignalen jeweils um einen Strom handelt, wird beispielsweise für jede Phase des Transformators gleichzeitig ein Strom erzeugt, welcher durch die der jeweiligen Phase zugeordneten Wicklung und den der Wicklung zugeordneten Stufenschalter, welcher in Reihe mit der jeweiligen Wicklung liegt, fließt. Wenn es sich bei den Testsignalen jeweils um eine Spannung handelt, wird beispielsweise für jede Phase des Transformators gleichzeitig eine Spannung an die dieser Phase zugeordneten Wicklung angelegt, um dadurch einen Strom durch diese Wicklung und den zugeordneten Stufenschalter zu erzeugen. Die Stufenschalter werden betätigt, wobei bei jedem Betätigen das Übersetzungsverhältnis geändert wird. Dabei sollten die Stufenschalter alle gleichzeitig betätigt werden. Während der Betätigung der Stufenschalter wird für jede dem jeweiligen Stufenschalter zugeordneten Wicklung ein transienter elektrischer Widerstandswert oder ein zeitlicher Verlauf dieses Widerstandswerts, welcher sich abhängig von dem Testsignal während des Schaltvorgangs ändert, erfasst. Das Erfassen des jeweiligen Widerstandswerts erfolgt dabei insbesondere wiederum mit mindestens einer Messgröße, wie es vorab beschrieben ist. Dabei kann es sich bei einer Messgröße um einen elektrischen Strom, welcher durch eine der Wicklungen und den dieser Wicklung zugeordneten in Reihe mit dieser Wicklung liegenden Stufenschalter fließt, handeln. Bei einer anderen Messgröße kann es sich um eine elektrische Spannung handeln, welche an einer der Wicklungen abfällt.

Anhand des für die jeweilige Phase erfassten Widerstandswerts kann entschieden werden, ob der jeweilige Stufenschalter des Mehrphasen-Transformators korrekt arbeitet. Dabei kann der für die jeweilige Phase erfasste Widerstandswert mit einem entsprechenden Widerstandswert bei einem korrekt arbeitenden Stufenschalter verglichen werden.

Die Testsignale können für jede Phase so erzeugt werden, dass die Testsignale denselben Betrag aufweisen, wodurch die für verschiedene Phasen erfassten Widerstandswerte vorteilhafterweise miteinander vergleichbar sind.

Bei einem dreiphasigen Transformator mit Sternpunktanschluss, welcher vorzugsweise eine Y- oder eine Z-Wicklung aufweist, können alle drei Phasen gleichzeitig geprüft werden. Dazu kann als Testsignal ein Strom eingeprägt werden, welcher bei zwei Phasen in die Wicklung hinein (d.h. bei dem dem Sternpunkt abgewandten Ende der Wicklung eingeprägt wird) und bei einer Phase hinaus (d.h. an dem dem Sternpunkt abgewandten Ende von der Wicklung abgezogen wird) fließt. Wenn die drei Ströme vom Betrag her gleich sind, fließt zusätzlich noch ein vierter Strom hinaus (d.h. er wird an dem dem Sternpunkt abgewandten Ende von der Wicklung abgezogen).

Sowohl bei einem Mehrphasen-Transformator als auch bei einem einphasigen Transformator kann es sich bei dem Testsignal um ein Gleichstromsignal, d.h. um einen elektrischen Gleichstrom, handeln.

Wie zumindest teilweise vorab beschrieben ist, kann der elektrische Widerstandswert anhand elektrischer Messgrößen bestimmt werden. Bei der einen Messgröße handelt es sich um den elektrischen Strom, welcher durch die jeweilige Wicklung und den dieser Wicklung zugeordneten Stufenschalter fließt, und bei der anderen Messgröße handelt es sich um die elektrische Spannung, welche an der jeweiligen Wicklung abfällt, so dass der elektrische Widerstandswert abhängig von der Spannung und dem Strom (insbesondere als Quotient aus der Spannung und dem Strom) berechnet wird. Bei diesem Widerstandswert kann es sich um einen ohmschen Widerstandswert bzw. Gleichstromwiderstandswert oder um einen Impedanzwert bzw. Wechselstromwiderstand handeln.

Erfindungsgemäß kann es sich bei der mindestens einen Messgröße auch um andere elektrische Größen, wie z.B. die elektrische Leistung oder die elektrische Energie, welche von der jeweiligen Wicklung aufgenommen oder von dieser abgegeben wird, handeln. Auch in diesem Fall ist es möglich, den elektrischen Widerstandswert ausgehend von der mindestens einen Messgröße zu bestimmen.

Erfindungsgemäß ist es zum einen möglich, den erfassten elektrischen Widerstandswert automatisch auszuwerten, um den Stufenschalter zu prüfen oder um eine Entscheidung zu treffen, ob der jeweilige Stufenschalter korrekt arbeitet. Zum anderen ist es erfindungsgemäß allerdings auch möglich, den jeweiligen elektrischen Widerstandswert auszugeben, um beispielsweise einen Experten anhand der Ausgabe entscheiden zu lassen, ob der jeweilige Stufenschalter korrekt arbeitet.

Insbesondere, wenn das Erfassen und/oder Bestimmen des jeweiligen elektrischen Widerstandswerts ein Erfassen und/oder Bestimmen eines zeitlichen Verlaufs des jeweiligen elektrischen Widerstandswerts umfasst, umfasst das Ausgeben des jeweiligen elektrischen Widerstandswerts vorteilhafterweise ein Darstellen des zeitlichen Verlaufs des jeweiligen elektrischen Widerstandswerts.

Zur Prüfung des jeweiligen Stufenschalters können mehrere erfasste zeitliche Verläufe des elektrischen Widerstandswerts, welche bei mehreren Betätigungen des jeweiligen Stufenschalters erfasst und/oder bestimmt werden, automatisch zeitlich überlagert dargestellt werden. Die Darstellung der Verläufe erfolgt dabei insbesondere über eine Anzeige bzw. einen Bildschirm. Es ist allerdings auch möglich, die Verläufe zu ihrer Darstellung auf einem Drucker auszudrucken oder auf anderen Medien darzustellen. Unter der zeitlich überlagerten Darstellung der Verläufe wird dabei insbesondere verstanden, dass ein zeitliches Ende jedes der dargestellten Verläufe nach allen zeitlichen Anfängen der dargestellten Verläufe aufgetragen wird. Die dargestellten (zeitlich überlagerten) Verläufe der elektrischen Widerstandswerte können auch anhand historischer Daten (z. B. vorher erfasster Verläufe des Widerstandswerts) ausgewertet werden.

Bei der zeitlich überlagerten Darstellung der Verläufe der jeweils erfassten elektrischen Widerstandswerte gibt es zum einen die Möglichkeit, die Verläufe möglichst deckungsgleich aufzutragen, so dass beispielsweise zwei identische Verläufe genau übereinander dargestellt werden. Eine andere erfindungsgemäße Möglichkeit besteht darin, die Verläufe (leicht) versetzt aufzutragen, so dass beispielsweise zwei identische Verläufe unterschieden werden können. Dabei können die Verläufe entweder in Richtung der Zeitachse und/oder senkrecht zu der Zeitachse versetzt dargestellt werden.

Zur zeitlich überlagerten Darstellung der Verläufe werden insbesondere einander entsprechende Zeitabschnitte der Verläufe zeitlich überlagert dargestellt. Dabei kann der jeweils entsprechende Zeitabschnitt bzw. das jeweils entsprechende Zeitintervall des jeweiligen Verlaufs kurz vor oder kurz nach der jeweiligen Betätigung des Stufenschalters beginnen und nach dem Ende der Durchführung der Umschaltung auf ein neues Übersetzungsverhältnis enden. Der jeweilige Zeitabschnitt des jeweiligen Verlaufs kann beispielsweise 100 ms des jeweiligen Umschaltvorgangs betragen.

Das Zeitintervall, während welchem der Verlauf des jeweiligen Widerstandswerts erfasst wird, kann so lang gewählt werden, dass der Transformator nach dem Umschalten auf das neue Übersetzungsverhältnis in die Sättigung kommt, so dass der erfasste Widerstandswert auch den Widerstand der Wicklung umfasst.

Im Rahmen der vorliegenden Erfindung wird auch eine Vorrichtung zum Prüfen eines Stufenschalters eines Transformators bereitgestellt. Dabei ist der Stufenschalter ausgestaltet, um (unter Last bzw. im Betrieb) ein Übersetzungsverhältnis des Transformators zu ändern. Die Vorrichtung umfasst Testsignalerzeugungsmittel, Messmittel und Steuermittel. Mit Hilfe der Testsignalerzeugungsmittel und der Steuermittel erzeugt die Vorrichtung ein Testsignal, welches einer Wicklung des Transformators und dem Stufenschalter zugeführt wird. Mit Hilfe der Messmittel und der Steuermittel ist die Vorrichtung in der Lage, einen elektrischen Widerstandswert des Transformators während einer Betätigung des Stufenschalters in Abhängigkeit von dem Testsignal zu erfassen und/oder zu bestimmen.

Die Vorteile der erfindungsgemäßen Vorrichtung entsprechen im Wesentlichen den Vorteilen des erfindungsgemäßen Verfahrens, welche vorab im Detail ausgeführt sind, so dass hier auf eine Wiederholung verzichtet wird.

Gemäß einer erfindungsgemäßen Ausführungsform kann es sich bei dem Transformator um einen Mehrphasen-Transformator handeln, wobei für jede Phase des Transformators ein separater Stufenschalter vorhanden ist, welcher ausgestaltet ist, um (unter Last) ein Übersetzungsverhältnis des Transformators zu ändern. Gemäß dieser erfindungsgemäßen Ausführungsform ist die Vorrichtung somit zum Prüfen eines bzw. der Stufenschalter eines Mehrphasen-Transformators ausgestaltet. Darüber hinaus ist die Vorrichtung ausgestaltet, um mit Hilfe der Testsignalerzeugungsmittel gleichzeitig jeweils ein Testsignal für jede Phase des Transformators zu erzeugen und um diese Testsignale jeweils (d.h. jeweils eines dieser Testsignale) einer der jeweiligen Phase zugeordneten Wicklung des Transformators und dem dieser Wicklung zugeordneten Stufenschalter zuzuführen. Die Vorrichtung ist in der Lage, um mit Hilfe der Messmittel und der Steuermittel für jede Wicklung einen elektrischen Widerstandswert während einer Betätigung der Stufenschalter abhängig von dem Testsignal zu erfassen.

Die Vorteile dieser erfindungsgemäßen Ausführungsform entsprechen im Wesentlichen den Vorteilen der entsprechenden Ausführungsform des erfindungsgemäßen Verfahrens, welche vorab im Detail ausgeführt sind, so dass hier auf eine Wiederholung verzichtet wird.

Die Vorrichtung umfasst insbesondere eine Anzeige und ist derart ausgestaltet, dass die Vorrichtung mit Hilfe der Steuermittel den Widerstandswert oder zeitliche Verläufe des Widerstandswerts auf dieser Anzeige darstellt.

Durch die Ausgabe des elektrischen Widerstandswerts und insbesondere durch die grafische Darstellung von zeitlich überlagerten Verläufen des elektrischen Widerstandswerts für den jeweiligen Stufenschalter wird die Interpretation des erfassten Widerstandswerts im Vergleich zum Stand der Technik vereinfacht. Dadurch wird letztlich auch die Prüfung des Stufenschalters vereinfacht.

Die vorliegende Erfindung kann insbesondere zur Prüfung von Stufenschaltern von Leistungstransformatoren eingesetzt werden. Selbstverständlich ist die vorliegende Erfindung nicht auf diesen bevorzugten Anwendungsbereich eingeschränkt, da die Erfindung beispielsweise auch zur Prüfung von Stufenschaltern von Transformatoren, welche nicht als Leistungstransformatoren gelten, eingesetzt werden kann.

Im Folgenden wird die vorliegende Erfindung anhand bevorzugter erfindungsgemäßer Ausführungsformen mit Bezug zu den Figuren im Detail beschrieben.

In Fig. 1 sind mehrere zeitliche Verläufe eines elektrischen Stroms beim Betätigen eines Stufenschalters eines Transformators dargestellt.

In Figuren 2-4 sind nur bestimmte der in Fig. 1 dargestellten zeitlichen Verläufe dargestellt.

In Fig. 5 sind die zeitlichen Verläufe eines elektrischen Stroms beim Betätigen eines Stufenschalters eines Transformators nicht zeitlich überlagert, sondern zeitlich hintereinander dargestellt.

In Fig. 6 ist ein Transformator mit Stufenschalter zusammen mit einer erfindungsgemäßen Vorrichtung dargestellt.

In Fig. 7 ist ein Mehrphasen-Transformator zusammen mit einer erfindungsgemäßen Vorrichtung dargestellt.

In Fig. 8 ist schematisch eine erfindungsgemäße Vorrichtung dargestellt.

Obwohl in den folgenden Figuren beispielhaft sowohl als Testsignal als auch als Messgröße jeweils ein elektrischer Strom dargestellt ist, sei explizit darauf hingewiesen, dass erfindungsgemäß als Testsignal auch eine Spannung angelegt werden kann und/oder dass als Messgröße auch eine Spannung, ein elektrischer Widerstand, eine Impedanz, eine Leistung, eine Energie usw. eingesetzt bzw. erfasst werden kann, um abhängig von der Messgröße einen elektrischen Widerstandswert des Transformators zu bestimmen.

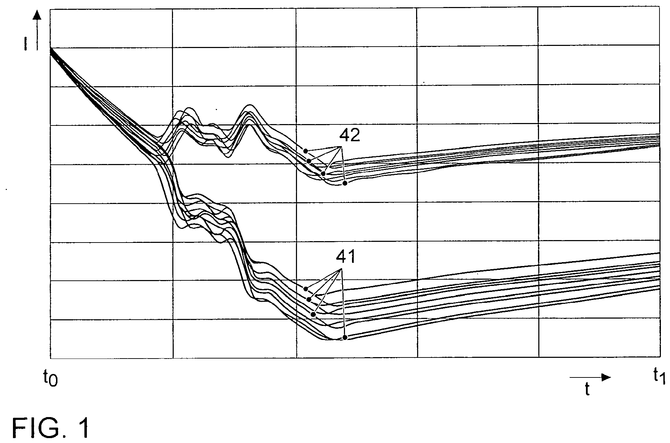

In Fig. 1 sind mehrere zeitliche Verläufe 41, 42 eines elektrischen Stroms zeitlich überlagert dargestellt, wobei jeder der Verläufe 41, 42 bei der Betätigung eines Stufenschalters eines Transformators erfasst wird. Der elektrische Strom, dessen Verlauf erfasst wird, fließt dabei durch die Wicklung und den in Reihe mit der Wicklung liegenden Stufenschalter. Für jeden der Verläufe wird jeweils ein Zeitabschnitt dargestellt, welcher bei einem ersten Zeitpunkt t₀ beginnt und bei einem zweiten Zeitpunkt t₁ endet. Dabei liegt der erste Zeitpunkt t₀ kurz nach Beginn der Betätigung des Stufenschalters und der zweite Zeitpunkt t₁ liegt zeitlich nach dem Ende des Umschaltvorgangs des Stufenschalters.

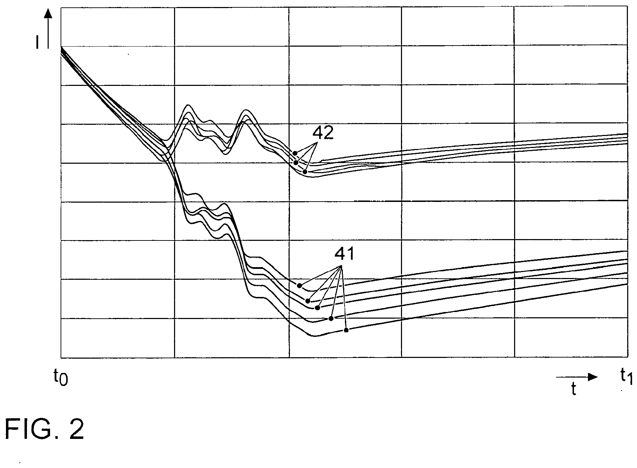

Wenn zusätzlich zum elektrischen Strom auch eine über der Wicklung abfallende Spannung über der Zeit erfasst wird, kann anhand eines Quotienten aus der Spannung und dem Strom ein zeitlicher Verlauf eines elektrischen Widerstandswerts ermittelt werden. In diesem Fall könnten die zeitlichen Verläufe des Widerstandswerts so zeitlich überlagert dargestellt werden, wie in Fig. 1 (und in Figuren 2 bis 4) die zeitlichen Verläufe des Stroms dargestellt sind.

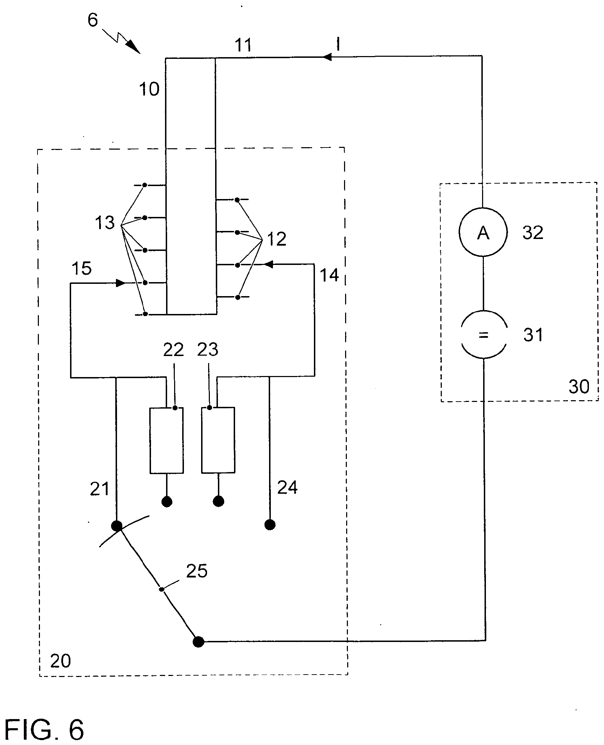

Im vorliegenden Fall weist die Wicklung elf Abgriffe oder Anzapfungen auf, zwischen welchen der Stufenschalter umschalten kann, wie es genauer mit Fig. 6 erläutert wird. Die mit dem Bezugszeichen 41 gekennzeichneten Verläufe zeigen jeweils einen von zehn Stromverläufen, welche erfasst werden, wenn der Stufenschalter aufwärts schaltet, wodurch sich die Anzahl der effektiven Windungen der Wicklung verringert. In ähnlicher Weise zeigen die mit dem Bezugszeichen 42 gekennzeichneten Verläufe jeweils einen von zehn Stromverläufen, welche erfasst werden, wenn der Stufenschalter abwärts schaltet, wodurch sich die Anzahl der effektiven Windungen der Wicklung vergrößert.

Wie in Fig. 6 dargestellt ist, existieren linksseitige oder ungeradzahlige Abgriffe 13 und rechtsseitige oder geradzahlige Abgriffe 12 der Wicklung 10. In Fig. 2 sind nur die Stromverläufe 41, 42 bei geradzahligen Schaltvorgängen dargestellt, indem die Stromverläufe bei ungeradzahligen Schaltvorgängen mittels Filtern unterdrückt werden. Ein geradzahliger Schaltvorgang liegt dabei dann vor, wenn auf einen geradzahligen oder rechtsseitigen Abgriff 12 umgeschaltet wird. Dabei kann sowohl bei einem Abwärtsschalten als auch bei einem Aufwärtsschalten auf einen geradzahligen oder rechtsseitigen Abgriff 12 umgeschaltet werden. Mit anderen Worten zeigen die mit dem Bezugszeichen 41 in Fig. 2 gekennzeichneten Stromverläufe fünf geradzahlige Schaltvorgänge beim Abwärtsschalten, während die mit dem Bezugszeichen 42 in Fig. 2 gekennzeichneten Stromverläufe fünf geradzahlige Schaltvorgänge beim Aufwärtsschalten darstellen.

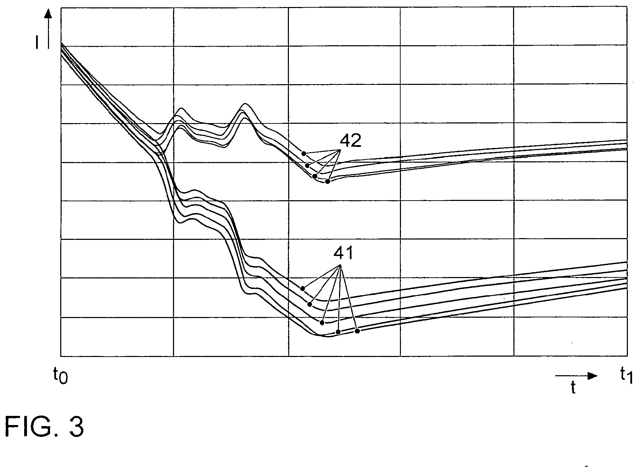

Dagegen sind in Fig. 3 nur die Stromverläufe 41, 42 bei ungeradzahligen Schaltvorgängen dargestellt, indem die Stromverläufe bei geradzahligen Schaltvorgängen mittels Filtern unterdrückt werden. Ein ungeradzahliger Schaltvorgang liegt dann vor, wenn auf einen ungeradzahligen oder linksseitigen Abgriff 13 (siehe Fig. 6) umgeschaltet wird. Wie bei den geradzahligen Schaltvorgängen, kann bei den ungeradzahligen Schaltvorgängen sowohl bei einem Abwärtsschalten als auch bei einem Aufwärtsschalten auf einen ungeradzahligen oder linksseitigen Abgriff 13 umgeschaltet werden. Anders ausgedrückt zeigen die mit dem Bezugszeichen 41 in Fig. 3 gekennzeichneten Stromverläufe fünf ungeradzahlige Schaltvorgänge beim Abwärtsschalten, während die mit dem Bezugszeichen 42 in Fig. 3 gekennzeichneten Stromverläufe fünf ungeradzahlige Schaltvorgänge beim Aufwärtsschalten darstellen.

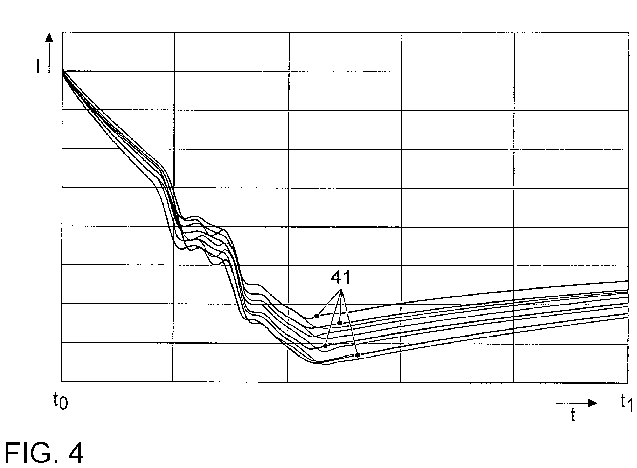

In Fig. 4 sind nur die zehn Stromverläufe 41 bei geradzahligen Schaltvorgängen dargestellt, so dass die zehn Stromverläufe 42 bei ungeradzahligen Schaltvorgängen (siehe Fig. 1) nicht dargestellt sind, da sie herausgefiltert wurden.

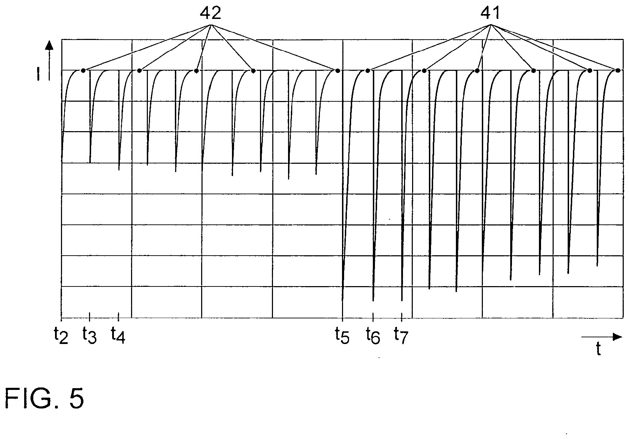

In Fig. 5 sind die 20 Stromverläufe 41, 42 aus Fig. 1 zeitlich nebeneinander dargestellt. Dabei entspricht ein Zeitpunkt (z.B. t₃ oder t₆), zu welchem ein Stromverlauf 41, 42 endet, einem Zeitpunkt, zu welchem ein benachbart dazu dargestellter Stromverlauf beginnt. Mit anderen Worten sind die in Fig. 5 dargestellten Stromverläufe nicht zeitlich überlagert dargestellt.

In Fig. 6 sind ein Transformator 6 mit einem Stufenschalter 20 und eine erfindungsgemäße Vorrichtung 30 zum Prüfen des Stufenschalters 20 dargestellt.

Der Transformator 6 umfasst eine Wicklung 10, welche mehrere Abgriffe oder Anzapfungen 12, 13 aufweist. Der Stufenschalter 20 umfasst zwei Stufenwähler 14, 15. Dabei ist der eine Stufenwähler 14 mit einem der rechtsseitigen oder geradzahligen Abgriffe 12 und der andere Stufenwähler 15 mit einem der linksseitigen oder ungeradzahligen Abgriffe 13 verbunden. Darüber hinaus umfasst der Stufenschalter 20 einen ersten Anschluss 21 und einen ersten Widerstand 22, welche dem Stufenwähler 15 zugeordnet sind, sowie einen zweiten Anschluss 24 und einen zweiten Widerstand 23, welche dem Stufenwähler 14 zugeordnet sind. Bei dem in Fig. 6 dargestellten Zustand fließt ein Strom I bei Anschluss 11 in die Wicklung 10 hinein und bei dem Abgriff 13, welcher mit dem Stufenwähler 15 in Kontakt steht, aus der Wicklung 10 heraus.

Um nun das Übersetzungsverhältnis des Transformators 6 zu ändern, wird ein Umschalter 25 des Stufenschalters 20 vom Anschluss 21 zum Anschluss 24 geschaltet. Dabei kontaktiert der Umschalter 25 in einem ersten Schritt sowohl den ersten Anschluss 21 als auch den ersten Widerstand 22, so dass der Strom I durch den ersten Widerstand 22 fließt, wenn der Umschalter 25 im zweiten Schritt den Kontakt zum ersten Anschluss 21 verliert. Im dritten Schritt kontaktiert der Umschalter 25 sowohl den ersten Widerstand 22 als auch den zweiten Widerstand 23, so dass der Strom I sowohl über den ersten Widerstand 22 als auch über den zweiten Widerstand 23 und damit sowohl über den Stufenwähler 15 und den entsprechenden Abgriff 13 als auch über den Stufenwähler 14 und den entsprechenden Abgriffe 12 fließt. Wenn der Umschalter 25 weiter geschaltet wird, verliert der Umschalter 25 im vierten Schritt den Kontakt mit dem ersten Widerstand 22, so dass der Strom I im vierten Schritt nur über den zweiten Widerstand 23 und den Stufenwähler 14 und den entsprechenden Abgriff 12 fließt. Wenn der Umschalter 25 weiter geschaltet wird, kontaktiert der Umschalter 25 im fünften Schritt den zweiten Anschluss 24, so dass der zweite Widerstand 23 quasi kurzgeschlossen wird. Der Strom I fließt über den zweiten Anschluss 24 sowie den Stufenwähler 14 und den zugehörigen Abgriff 12, so dass sich das Übersetzungsverhältnis des Transformators 6 entsprechend ändert. Wenn der Umschalter 25 weiter geschaltet wird, verliert der Umschalter 25 im sechsten und letzten Schritt den Kontakt zum zweiten Widerstand 23, womit der Umschaltvorgang oder die Betätigung des Stufenschalters 20 zur Änderung des Übersetzungsverhältnisses des Transformators 6 endgültig beendet ist.

Sobald der Stufenwähler 15 stromlos geschaltet ist (also mit dem vierten Schritt), kann der Stufenwähler mit einem anderen linksseitigen oder ungeradzahligen Abgriff 13 verbunden werden. Um das Übersetzungsverhältnis des Transformators 6 erneut zu ändern, wird der Umschalter 25 in ähnlicher Weise, wie vorab beschrieben, von dem zweiten Anschluss 24 zu dem ersten Anschluss 21 geschaltet.

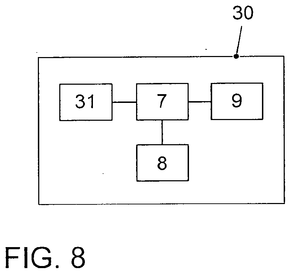

Zur Prüfung oder zum Test des Stufenschalters 20 existiert die erfindungsgemäße Vorrichtung 30, welche eine Stromquelle 31 und einen Strommesser 32 umfasst. Mit Hilfe der Stromquelle 31 wird der Strom I erzeugt, welcher durch die Wicklung 10 und den in Reihe mit der Wicklung 10 liegenden Stufenschalter 20 fließt. Insbesondere ein zeitlicher Verlauf des durch die Wicklung 10 und den Stufenschalter 20 fließenden Stroms I wird während des Umschaltens des Stufenschalters 20 mit einer entsprechenden Messeinrichtung 9 (siehe Fig. 8) der erfindungsgemäßen Vorrichtung 30 erfasst.

Wenn die Messeinrichtung 9 (siehe Fig. 8) zusätzlich ausgestaltet ist, um einen zeitlichen Verlauf der über der Wicklung 10 abfallenden Spannung zu erfassen, kann der zeitliche Verlauf des elektrischen Widerstandswerts der Wicklung 10 von der Steuerung 7 (siehe Fig. 8) der Vorrichtung 30 bestimmt werden, indem zu jedem Zeitpunkt die zu diesem Zeitpunkt erfasste Spannung durch den zu diesem Zeitpunkt erfassten Strom geteilt wird. Die erfindungsgemäße Vorrichtung 30 ist dann in der Lage, zeitliche Widerstandswertverläufe, welche während der Umschaltvorgänge des Stufenschalters 20 erfasst und bestimmt wurden, zeitlich überlagert darzustellen.

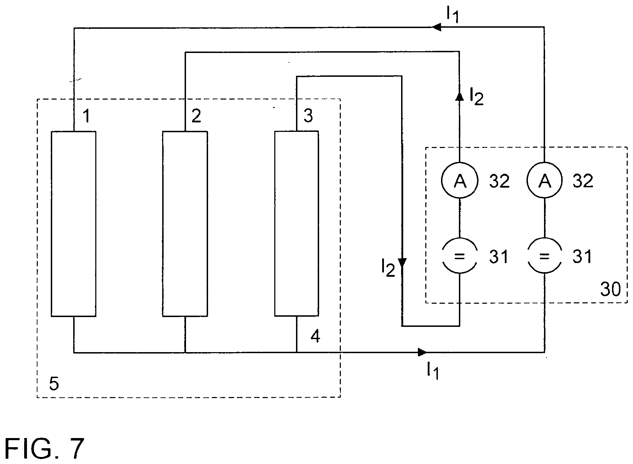

In Fig. 7 ist ein Mehrphasen-Transformator 5 dargestellt, welcher drei Phasen mit jeweils einer Wicklung 1-3 in Y-Verschaltung umfasst. Dabei weist jede Phase bzw. Wicklung 1-3 einen Stufenschalter 20 (in Fig. 7 nicht dargestellt) auf, um das Übersetzungsverhältnis des Transformators 5 in derselben Weise zu ändern, wie es vorab bezüglich Fig. 6 beschrieben ist.

Zur Prüfung der Stufenschalter erzeugt die erfindungsgemäße Vorrichtung 30 einen ersten Gleichstrom I₁, welcher dem dem Sternpunkt 4 abgewandten Ende der ersten Wicklung 1 zugeführt wird, und einen zweiten Gleichstrom I₂, welcher zum einen von dem dem Sternpunkt 4 abgewandten Ende der dritten Wicklung 3 abgezogen und zum anderen dem dem Sternpunkt 4 abgewandten Ende der zweiten Wicklung 2 zugeführt wird. Man erkennt, dass der erste Gleichstrom I₁ auch von dem Sternpunkt 4 zu der Vorrichtung 30 abfließt. Mit anderen Worten weisen die Testsignale bzw. Gleichströme I₁, I₂, welche jeder Wicklung 1-3 zugeführt werden, denselben Betrag auf.

Die zeitlichen Verläufe der Widerstandswerte der drei Wicklungen 1-3 werden erfasst, während die Stufenschalter mehrfach geschaltet werden, um das Übersetzungsverhältnis des Mehrphasen-Transformators 5 zu ändern. Pro Stufenschalter werden mehrere der erfassten bzw. bestimmten Widerstandswertverläufe zeitlich überlagert dargestellt, um den korrekten Betrieb der Stufenschalter zu überprüfen.

In Fig. 8 ist schematisch eine weitere Ausführungsform der erfindungsgemäßen Vorrichtung 30 dargestellt. Die Vorrichtung 30 umfasst neben einer Stromquelle 31, welche den Testsignalerzeugungsmitteln entspricht, eine Steuerung 7, eine Anzeige 8 und Messmittel 9, mit welchen ein zeitlicher Verlauf des elektrischen Widerstandswerts erfasst bzw. bestimmt werden kann. Auf der Anzeige 8 werden die erfassten bzw. bestimmten zeitlichen Verläufe des Widerstandswerts zeitlich überlagert dargestellt.

### BEZUGSZEICHENLISTE

- 1-3: Wicklung
- 4: Sternpunkt
- 5: Dreiphasenwechselstrom-Transformator
- 6: Transformator
- 7: Steuerung
- 8: Anzeige
- 9: Messeinrichtung
- 10: Wicklung
- 14, 15: Stufenwähler
- 12, 13: Stufe
- 20: Stufenschalter
- 11, 21, 24: Anschluss
- 22, 23: Widerstand
- 30: Vorrichtung
- 31: Stromquelle
- 32: Strommesser
- 41: Stromverlauf bei Abwärtsschalten
- 42: Stromverlauf bei Aufwärtsschalten
- I, I₁, I₂: Gleichstrom
- t: Zeit
- tₓ: Zeitpunkt

## Patentansprüche

1. Verfahren zum Prüfen eines Stufenschalters (20) eines Transformators (5; 6),
wobei der Stufenschalter (20) ausgestaltet ist, um ein Übersetzungsverhältnis des Transformators (5; 6) zu ändern,
wobei das Verfahren folgende Schritte umfasst:
Erzeugen eines Testsignals als elektrischer Strom (I; I₁; I₂), welcher durch eine Wicklung (1-3; 10) des Transformators (5; 6) und den in Reihe mit der Wicklung (1-3; 10) geschalteten Stufenschalter (20) fließt,
Betätigen des Stufenschalters (20), um das Übersetzungsverhältnis zu ändern, und
Erfassen eines elektrischen Widerstandswerts der Wicklung (1-3; 10) des Transformators (5, 6) während des Schritts des Betätigens des Stufenschalters (20) abhängig von dem Testsignal, wobei das Erfassen des elektrischen Widerstandswerts ein Messen des Stroms (I; I₁; I₂) durch die Wicklung (1-3; 10) und ein Messen einer Spannung, welche an der Wicklung (1-3; 10) abfällt, sowie ein Bestimmen des elektrischen Widerstandswerts anhand eines Quotienten aus der Spannung und dem Strom (I; I₁; I₂) umfasst.

2. Verfahren nach Anspruch 1,
**dadurch gekennzeichnet,**
**dass** der Transformator ein Mehrphasen-Transformator (5) ist,
**dass** für jede Phase des Transformators (5) ein separater Stufenschalter (20) vorhanden ist, welcher ausgestaltet ist, um ein Übersetzungsverhältnis des Transformators (5) zu ändern,
**dass** gleichzeitig jeweils ein Testsignal für jede Phase des Transformators (5) erzeugt wird, welches einer der jeweiligen Phase zugeordneten Wicklung (1-3) des Transformators (5) und dem der Wicklung (1-3) zugeordneten Stufenschalter (20) zugeführt wird,
**dass** die Stufenschalter (20) betätigt werden, um das Übersetzungsverhältnis zu ändern, und
**dass** jeweils ein elektrischer Widerstandswert für jede Wicklung (1-3) während des Schritts des Betätigens der Stufenschalter (20) erfasst wird.

3. Verfahren nach Anspruch 2,
**dadurch gekennzeichnet,**
**dass** die Testsignale für jede Phase vom Betrag her gleich erzeugt werden.

4. Verfahren nach einem der vorhergehenden Ansprüche,
**dadurch gekennzeichnet,**
**dass** das Testsignal ein Gleichstromsignal ist.

5. Verfahren nach einem der vorhergehenden Ansprüche,
**dadurch gekennzeichnet,**
**dass** der elektrische Widerstandswert ein Gleichstromwiderstandswert oder ein Wechselstromwiderstandswert ist.

6. Verfahren nach einem der vorhergehenden Ansprüche,
**dadurch gekennzeichnet,**
**dass** das Verfahren ein Ausgeben des jeweiligen elektrischen Widerstandswerts umfasst.

7. Verfahren nach Anspruch 6,
**dadurch gekennzeichnet,**
**dass** das Erfassen des jeweiligen elektrischen Widerstandswerts ein Erfassen eines Verlaufs des jeweiligen elektrischen Widerstandswerts über der Zeit (t) umfasst, und
**dass** das Ausgeben des jeweiligen elektrischen Widerstandswerts ein Darstellen des Verlaufs des jeweiligen elektrischen Widerstandswerts über der Zeit (t) umfasst.

8. Vorrichtung zum Prüfen eines Stufenschalters (20) eines Transformators (5; 6),
wobei der Stufenschalter (20) ausgestaltet ist, um ein Übersetzungsverhältnis des Transformators (5; 6) zu ändern,
wobei die Vorrichtung (30) Testsignalerzeugungsmittel (31), Messmittel (9) und Steuermittel (7) umfasst,
wobei die Vorrichtung (30) ausgestaltet ist, um mittels der Testsignalerzeugungsmittel (31) ein Testsignal als elektrischen Strom (I; I₁; I₂) zu erzeugen, welcher durch eine Wicklung (10) des Transformators (5; 6) und den in Reihe mit der Wicklung (10) geschalteten Stufenschalter (20) fließt, und
wobei die Vorrichtung (30) ausgestaltet ist, um mittels der Messmittel (9) und der Steuermittel (7) einen elektrischen Widerstandswert der Wicklung (1-3; 10) des Transformators (5; 6) während eines Betätigens des Stufenschalters (20) abhängig von dem Testsignal zu erfassen, wobei die Vorrichtung (30) ausgestaltet ist, um zum Erfassen des elektrischen Widerstandswerts mittels der Messmittel (9) und der Steuermittel (7) den Strom (I; I₁; I₂) durch die Wicklung (10) zu messen und eine Spannung, welche an der Wicklung (10) abfällt, zu messen sowie den elektrischen Widerstandswert anhand eines Quotienten aus der Spannung dem Strom (I; I₁; I₂) zu bestimmen..

9. Vorrichtung nach Anspruch 8,
**dadurch gekennzeichnet,**
**dass** der Transformator ein Mehrphasen-Transformator (5) ist, dass für jede Phase des Transformators (5) ein separater Stufenschalter (20) vorhanden ist, welcher ausgestaltet ist, um ein Übersetzungsverhältnis des Transformators (5) zu ändern,
**dass** die Vorrichtung (30) ausgestaltet ist, um mittels der Testsignalerzeugungsmittel (31) gleichzeitig jeweils ein Testsignal für jede Phase des Transformators (5) zu erzeugen und einer der jeweiligen Phase zugeordneten Wicklung (1-3) des Transformators (5) und dem der Wicklung (1-3) zugeordneten Stufenschalter (20) zuzuführen, und
**dass** die Vorrichtung (30) ausgestaltet ist, um mittels der Messmittel (9) und der Steuermittel (7) jeweils einen elektrischen Widerstandswert für jede Wicklung (1-3) eines Betätigens der Stufenschalter (20) abhängig von dem Testsignal zu erfassen.

10. Vorrichtung nach Anspruch 8 oder 9,
**dadurch gekennzeichnet,**
**dass** die Vorrichtung (30) eine Anzeige (8) umfasst, und
**dass** die Vorrichtung (30) ausgestaltet ist, dass die Steuermittel (7) jeden Widerstandswert auf der Anzeige (8) darstellen.

11. Vorrichtung nach einem der Ansprüche 8-10,
**dadurch gekennzeichnet,**
**dass** die Vorrichtung (30) zur Durchführung des Verfahrens nach einem der Ansprüche 1-7 ausgestaltet ist.

## Claims

1. Method for testing a tap changer (20) of a transformer (5; 6),
wherein the tap changer (20) is configured to change a transmission ratio of the transformer (5; 6),
wherein the method comprises the following steps:
generating a test signal as an electric current (I; I₁; I₂) which flows through a winding (1-3; 10) of the transformer (5; 6) and the tap changer (20) connected in series with the winding (1-3; 10),
actuating the tap changer (20) in order to change the transmission ratio, and
determining an electrical resistance value of the winding (1-3; 10) of the transformer (5, 6) during the step of actuating the tap changer (20) depending on the test signal, wherein the determining of the electrical resistance value comprises a measurement of a current (I; I₁; I₂) through the winding (1-3; 10) and a measurement of a voltage which drops at the winding (1-3; 10) as well as a determining of the electrical resistance value by means of a quotient from the voltage and the current (I; I₁; I₂).

2. Method according to claim 1,
**characterised in that**
the transformer is a multi-phase transformer (5),
a separate tap changer (20), which is configured to change a transmission ratio of the transformer (5), is present for each phase of the transformer (5),
respectively one test signal is generated simultaneously for each phase of the transformer (5), which is supplied to a winding (1-3) of the transformer (5) assigned to the respective phase and to the tap changer (20) assigned to the winding (1-3),
the tap changers (20) are actuated in order to change the transmission ratio, and
respectively one electrical resistance value is determined for each winding (1-3) during the step of actuating the tap changers (20).

3. Method according to claim 2,
**characterised in that**
the test signals for each phase are generated identically in terms of magnitude.

4. Method according to any one of the preceding claims,
**characterised in that**
the test signal is a direct current signal.

5. Method according to any one of the preceding claims,
**characterised in that**
the electrical resistance value is a direct current resistance value or an alternating current resistance value.

6. Method according to any one of the preceding claims,
**characterised in that**
the method comprises outputting the respective electrical resistance value.

7. Method according to claim 6,
**characterised in that**
the determining of the respective electrical resistance value comprises a determining of a curve of the respective electrical resistance value over time (t), and
the outputting of the respective electrical resistance value comprises an illustrating of the curve of the respective electrical resistance value over time (t).

8. Device for testing a tap changer (20) of a transformer (5; 6),
wherein the tap changer (20) is configured to change a transmission ratio of the transformer (5; 6),
wherein the device (30) comprises test signal generation means (31), measuring means (9) and control means (7),
wherein the device (30) is configured to generate, by means of the test signal generation means (31), a test signal as an electric current (I; I₁; I₂) which flows through a winding (10) of the transformer (5; 6) and the tap changer (20) connected in series with the winding (10), and
wherein the device (30) is configured to determine, by means of the measuring means (9) and the control means (7), an electrical resistance value of the winding (1-3; 10) of the transformer (5; 6) during an actuation of the tap changer (20) depending on the test signal, wherein for determining the electrical resistance value the device (30) is configured to measure, by means of the measuring means (9) and the control means (7), the current (I; I₁; I₂) through the winding (10) and a voltage which drops at the winding (10) as well as to determine the electrical resistance value by means of a quotient from the voltage and the current (I; I₁; I₂).

9. Device according to claim 8,
**characterised in that**
the transformer is a multi-phase transformer (5),
a separate tap changer (20), which is configured to change a transmission ratio of the transformer (5), is present for each phase of the transformer (5),
the device (30) is configured to simultaneously generate respectively one test signal for each phase of the transformer (5) by means of the test signal generation means (31) and to supply said test signal to a winding (1-3) of the transformer (5) assigned to the respective phase and to the tap changer (20) assigned to the winding (1-3), and
the device (30) is configured to determine by means of the measuring means (9) and the control means (7) respectively one electrical resistance value for each winding (1-3) during an actuation of the tap changer (20) depending on the test signal.

10. Device according to claim 8 or 9,
**characterised in that**
the device (30) comprises a display (8), and
the device (30) is configured such that the control means (7) illustrate each resistance value on the display (8).

11. Device according to any one of claims 8-10,
**characterised in that**
the device (30) is designed to perform the method according to any one of claims 1-7.

## Revendications

1. Procédé de contrôle d'un commutateur à plots (20) d'un transformateur (5 ; 6),
dans lequel le commutateur à plots (20) est conçu pour modifier un rapport de transmission du transformateur (5 ; 6),
dans lequel le procédé comprend les étapes suivantes :
génération d'un signal de test en tant que courant électrique (I; I₁; I₂), lequel circule à travers un enroulement (1-3 ; 10) du transformateur (5 ; 6) et le commutateur à plots (20) connecté en série avec l'enroulement (1-3 ; 10),
actionnement du commutateur à plots (20) pour modifier le rapport de transmission, et
saisie d'une valeur de résistance électrique de l'enroulement (1-3 ; 10) du transformateur (5, 6) pendant l'étape d'actionnement du commutateur à plots (20) en fonction du signal de test, dans lequel la saisie de la valeur de résistance électrique comprend une mesure du courant (I; I₁; I₂) à travers l'enroulement (1-3 ; 10) et une mesure d'une tension, laquelle chute au niveau de l'enroulement (1-3 ; 10), ainsi qu'une détermination de la valeur de résistance électrique à l'aide d'un quotient de la tension et du courant (I; I₁; I₂).

2. Procédé selon la revendication 1,
**caractérisé en ce que**
le transformateur est un transformateur polyphasé (5),
**en ce qu'**un commutateur à plots (20) séparé est présent pour chaque phase du transformateur (5), lequel est conçu pour modifier un rapport de transmission du transformateur (5),
**en ce que** respectivement un signal de test est généré simultanément pour chaque phase du transformateur (5), lequel est alimenté à un enroulement (1-3) du transformateur (5) affecté à la phase respective et au commutateur à plots (20) affecté à l'enroulement (1-3),
**en ce que** les commutateurs à plots (20) sont actionnés pour modifier le rapport de transmission, et
**en ce que** respectivement une valeur de résistance électrique est saisie pour chaque enroulement (1-3) pendant l'étape d'actionnement des commutateurs à plots (20).

3. Procédé selon la revendication 2,
**caractérisé en ce que**
les signaux de test sont générés de manière identique en matière de quantité pour chaque phase.

4. Procédé selon l'une quelconque des revendications précédentes,
**caractérisé en ce que**
le signal de test est un signal de courant continu.

5. Procédé selon l'une quelconque des revendications précédentes,
**caractérisé en ce que**
la valeur de la résistance électrique est une valeur de résistance en courant continu ou une valeur de résistance en courant alternatif.

6. Procédé selon l'une quelconque des revendications précédentes,
**caractérisé en ce que**
le procédé comprend l'émission de la valeur de résistance électrique respective.

7. Procédé selon la revendication 6,
**caractérisé en ce que**
la saisie de la valeur de résistance électrique respective comprend une saisie d'une évolution de la valeur de résistance électrique respective dans le temps (t), et
**en ce que** l'émission de la valeur de résistance électrique respective comprend une représentation de l'évolution de la valeur de résistance électrique respective dans le temps (t).

8. Dispositif de contrôle d'un commutateur à plots (20) d'un transformateur (5 ; 6),
dans lequel le commutateur à plots (20) est conçu pour modifier un rapport de transmission du transformateur (5 ; 6),
dans lequel le dispositif (30) comprend des moyens de génération de signaux de test (31), des moyens de mesure (9) et des moyens de contrôle (7),
dans lequel le dispositif (30) est conçu pour générer, au moyen des moyens de génération de signaux de test (31), un signal de test en tant que courant électrique (I; I₁; I₂), lequel circule à travers un enroulement (10) du transformateur (5 ; 6) et le commutateur à plots (20) connecté en série avec l'enroulement (10),
et
dans lequel le dispositif (30) est conçu pour saisir, au moyen des moyens de mesure (9) et des moyens de contrôle (7), une valeur de résistance électrique de l'enroulement (1-3 ; 10) du transformateur (5; 6) pendant un actionnement du commutateur à plots (20) en fonction du signal de test, dans lequel le dispositif (30) est conçu pour mesurer le courant (I; I₁; I₂) à travers l'enroulement (10) au moyen des moyens de mesure (9) et des moyens de contrôle (7) pour la saisie de la valeur de résistance électrique et pour mesurer une tension, laquelle chute au niveau de l'enroulement (10), ainsi que pour déterminer la valeur de résistance électrique à l'aide d'un quotient de la tension et du courant (I; I₁; I₂).

9. Dispositif selon la revendication 8,
**caractérisé en ce que**
le transformateur est un transformateur polyphasé (5),
**en ce que**, pour chaque phase du transformateur (5), un commutateur à plots (20) séparé est présent, lequel est conçu pour modifier un rapport de transmission du transformateur (5),
**en ce que** le dispositif (30) est conçu pour générer respectivement simultanément un signal de test pour chaque phase du transformateur (5) au moyen des moyens de génération de signaux de test (31) et pour le fournir à un enroulement (1-3) du transformateur (5) affecté à la phase respective et au commutateur à plots (20) affecté à l'enroulement (1-3), et
**en ce que** le dispositif (30) est conçu pour saisir, au moyen des moyens de mesure (9) et des moyens de contrôle (7), respectivement une valeur de résistance électrique pour chaque enroulement (1-3) d'un actionnement du commutateur à plots (20) en fonction du signal de test.

10. Dispositif selon la revendication 8 ou 9,
**caractérisé en ce que**
le dispositif (30) comprend un affichage (8), et
**en ce que** le dispositif (30) est conçu de sorte que les moyens de contrôle (7) représentent chaque valeur de résistance sur l'affichage (8).

11. Dispositif selon l'une quelconque des revendications 8-10,
**caractérisé en ce que**
le dispositif (30) est conçu pour exécuter le procédé selon l'une quelconque des revendications 1-7.
